# EUROPEAN PATENT APPLICATION

(11) **EP 4 718 875 A1**
(43) Date of publication of application: **01.04.2026**
(21) Application number: 25203444.2
(22) Date of filing: 19.09.2025
(51) Int. Cl.: H04R 17/00

(54) **ELECTROACOUSTIC TRANSDUCER WITH ELECTRICAL CONNECTIONS ON A MEMBRANE**

(30) Priority: 30.09.2024 IT 202400021567
(71) Applicant: STMicroelectronics International N.V., 1228 Plan-les-Ouates, Geneva (CH)
(72) Inventor: CERINI, Fabrizio, 20013 MAGENTA (MI) (IT); CUNEO, Federico, 20864 AGRATE BRIANZA (MB) (IT)
(74) Representative: Studio Torta S.p.A.

(57) **Abstract**

A microelectromechanical electroacoustic transducer includes: a supporting frame (12) containing semiconductor material; a membrane (13) of semiconductor material connected to the supporting frame (12) along a perimeter; a central piezoelectric transducer (15) on a central portion (13b) of the membrane (13); elastic elements (17), defined by respective portions of the membrane (13), the central portion (13b) of the membrane (13) being connected to the supporting frame (12) by elastic elements (17); and metal lines (30, 35, 36) extending on respective elastic elements (17) and on the central portion (13b) of the membrane (13) from the elastic elements (17) to the central piezoelectric transducer (15). The metal lines (30, 35, 36) are of a metal immune to oxidation by exposure to the atmosphere.

## Description

### Technical Field

The present invention relates to an electroacoustic transducer with electrical connections on a membrane.

### Background

As is known, the users of the vast majority of mobile and land processing and communication devices, such as smartphones, tablets, portable and desktop computers, benefit from the use of headphones and earphones, which are by now extremely widespread. This spread, together with the fact that in many cases headphones and earphones are worn continuously for long periods of time, brings with it the need to provide comfortable and practical devices, without sacrificing the quality of audio reproduction. There is therefore an important push towards the manufacture of miniaturized electroacoustic transducers, such as speakers and microphones. Other miniaturized electroacoustic transducers towards which there is growing interest are used for example in probes for ultrasound inspection and, in general, in ultrasound imaging (Piezoelectric Micromachined Ultrasonic Transducer, PMUT).

However, the solutions currently available are not entirely satisfactory and do not represent a valid compromise between dimensions, performances in terms of high Sound Pressure Level (SPL - for transmitters) or sensitivity (for receivers) and costs.

A first type of electroacoustic transducer, in particular a speaker, utilizes traditional electromagnetic actuation and is capable of ensuring high reproduction quality. However, electromagnetic actuation speakers are not suitable for being miniaturized beyond a certain limit.

Other solutions based on MEMS (Micro-ElectroMechanical-Systems) technology allow better miniaturization levels to be obtained, but costs and/or performances are not yet suitable and such as to replace the electrodynamic speakers.

For example, hybrid devices are known wherein a microelectromechanical actuator, often of the piezoelectric type, is coupled to a polymeric membrane, which is caused to vibrate. The polymeric membrane has the advantage of high yielding (low Young's modulus), which allows a good response, but has critical issues from the point of view of process and costs. In fact, the membrane is applied to the portion of the device that houses the actuator only in the *back-end* step, i.e. in dedicated processing steps, successive to the manufacture of the same actuator. Furthermore, hybrid micro-speakers are not suitable for being assembled on boards by using SMT (Surface Mount Technology), because the membrane is not capable of withstanding soldering temperatures.

Other devices made entirely by using MEMS technology meet the miniaturization and cost requirements, but do not achieve sufficient performances as to response dynamics and bandwidth.

In particular, some micro-speakers comprise a semiconductor membrane connected to a supporting frame along its perimeter. The criticality of these devices lies mainly in the poor yielding of the membrane. In fact, to obtain a suitable sound pressure level, the area reduction of the membrane due to miniaturization should be compensated by a greater displacement (the sound pressure is in fact, as a first approximation, proportional to the product A*d, where A is the area of the membrane and d is the displacement). However, the stiffness of the semiconductor material does not allow a sufficient displacement, especially at low frequencies.

In other MEMS micro-speakers, the membrane is discontinuous in the inner portion precisely to have greater yielding and allow a wider displacement. More than a real membrane, the transducer comprises a plurality of cantilever structures, each of which defines a segment of a polygon or a sector of a circle and extends from a supporting frame. The vertices of the segments or sectors are adjacent to each other at the center of the transducer, without however being joined. A wider response dynamics may thus be obtained, which, however, is not constant on the audio bandwidth. A misalignment in the out-of-plane direction of the cantilever structures, again especially at low frequencies and resonance, may in fact lead to have uncontrolled widths between adjacent sectors, introducing vents in the membrane that may compromise the performances (acoustic short circuit), especially at low frequencies. Furthermore, the quality of the response of MEMS micro-speakers of this type is very influenced by process variations, since even small differences in the cantilever structures may cause nonuniform movements and dissymmetry in the sound emission, impacting on the Total Harmonic Distortion (THD). For example, the devices may simply be affected by the position in which they are formed on the semiconductor wafer. In particular, some characteristics such as zero-time deflection due to residual stresses of the materials may vary between devices that are located closer to the center or the periphery of the wafer.

### Summary

It is therefore an aim of the present invention to provide an electroacoustic transducer that allows the limitations described to be overcome or at least mitigated.

According to the present invention, an electroacoustic transducer is provided as defined in claim 1.

### Brief Description of the Figures

For a better understanding of the present invention, preferred embodiments are provided, by way of non-limiting example, with reference to the attached drawings, wherein:
- Figure 1 is a simplified block diagram of a processing and communication device;
- Figure 2 is a top-plan view of an electroacoustic transducer in accordance with an embodiment of the present invention incorporated into the device of Figure 1;
- Figure 3 shows the electroacoustic transducer of Figure 2 with parts removed for clarity;
- Figure 4 shows an enlarged detail of the electroacoustic transducer of Figure 2;
- Figure 5 is a cross-section through the electroacoustic transducer of Figure 2, sectioned along line V-V of Figure 2;
- Figure 6 is a cross-section through the electroacoustic transducer of Figure 2, sectioned along line VI-VI of Figure 2;
- Figure 7 shows another enlarged detail of the electroacoustic transducer of Figure 2;
- Figure 8 shows a further enlarged detail of the electroacoustic transducer of Figure 2;
- Figure 9 is a top-plan view of an electroacoustic transducer in accordance with a different embodiment of the present invention usable in the device of Figure 1;
- Figure 10 is a top-plan view of an electroacoustic transducer in accordance with a further embodiment of the present invention usable in the device of Figure 1; and
- Figure 11 is a top-plan view of a portion of an electroacoustic transducer in accordance with a further embodiment of the present invention usable in the device of Figure 1.

### Description of Embodiments

The following description refers to the arrangement shown in the drawings; consequently, expressions such as "above", "below", "upper", "lower", "top", "bottom", "right", "left" and the like relate to the accompanying Figures and are not to be interpreted in a limiting manner.

For convenience, hereinafter reference will be made to electroacoustic transducers used in micro-speakers. However, this is not to be understood in a limiting sense. Electroacoustic transducers according to the invention may be used in different devices, both receivers and transmitters, including microphones and ultrasound probes, and, in general, in the field of ultrasound imaging (PMUT, Piezoelectric Micromachined Ultrasonic Transducers).

Furthermore, here and below, the term transducer is intended to generically indicate a device that converts a first physical quantity (or form of energy) into a corresponding (different) second physical quantity (or form of energy) or vice versa. In some cases, possibly, a transducer may be used bidirectionally to convert the first physical quantity into the second physical quantity or the second physical quantity into the first physical quantity, according to the operating conditions. In particular, it is understood that an electroacoustic transducer is a device that converts acoustic waves into a corresponding electrical signal or, vice versa, converts an electrical signal into corresponding acoustic waves. Possibly, an electroacoustic transducer may be used bidirectionally both to convert acoustic waves into a corresponding electrical signal and to convert an electrical signal into corresponding acoustic waves (for example in ultrasound probes or in some earphones with active noise cancellation). Furthermore, it is understood that a piezoelectric transducer converts forces or pressures applied to faces of the same transducer into a corresponding electrical signal and an electrical signal into corresponding forces or pressures applied by faces of the transducer. The piezoelectric transducers are normally usable bidirectionally.

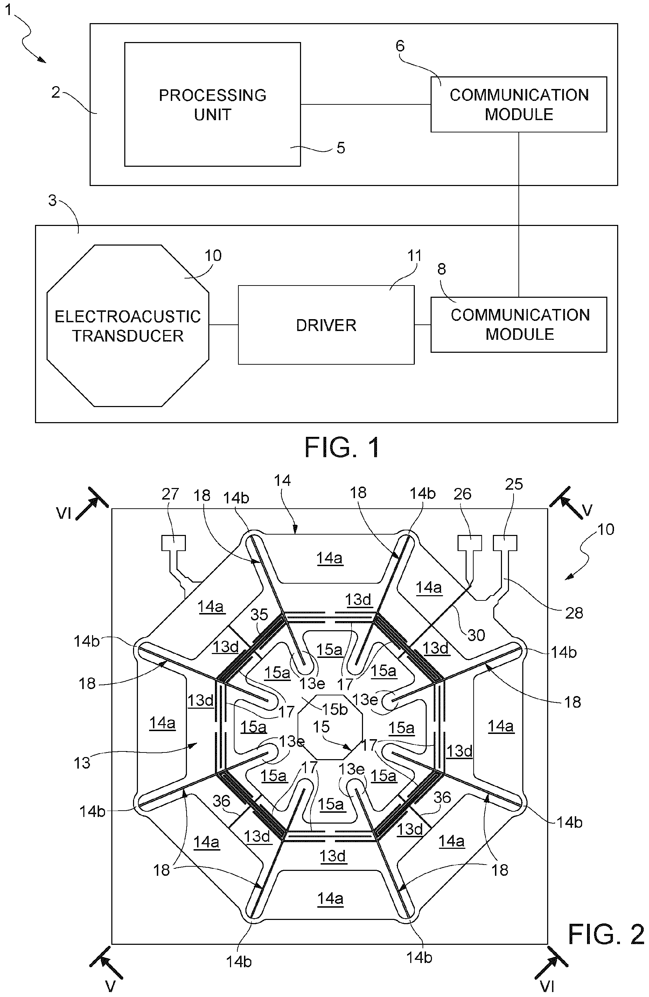

With reference to Figure 1, an electronic system denoted as a whole with the number 1 comprises a processing and communication device 2 coupled in communication with a micro-speaker 3.

The processing and communication device 2 may be any portable or land device that supports audio communication with a reproduction peripheral, such as the micro-speaker 3. The processing and communication device 2 may be, but it is not limited to, a portable computer, a personal computer, a tablet, a smartphone or a wearable device, for example a smartwatch, and comprises, in particular, a processing unit 5 and a communication module 6, coupled with a corresponding communication module 8 of the micro-speaker 3. The processing and communication device 2 may generally comprise further components not illustrated, such as a display unit, memory units, insertion and pointing devices, peripherals, a battery, I/O interfaces.

The micro-speaker 3 comprises, in addition to the communication module 8, an electroacoustic transducer 10 and a driver 11. The driver 11 receives audio signals through the communication module 8 and actuates the electroacoustic transducer 10.

The communication modules 6, 8 of the processing and communication device 2 and of the micro-speaker 3 may be mutually coupled by a wireless or cable connection.

With reference to Figures 2-6, the electroacoustic transducer 10 is a piezoelectric-type membrane microelectromechanical transducer and comprises a supporting frame 12, a membrane 13, and piezoelectric transducers, in particular a peripheral piezoelectric actuator 14 and a central piezoelectric actuator 15.

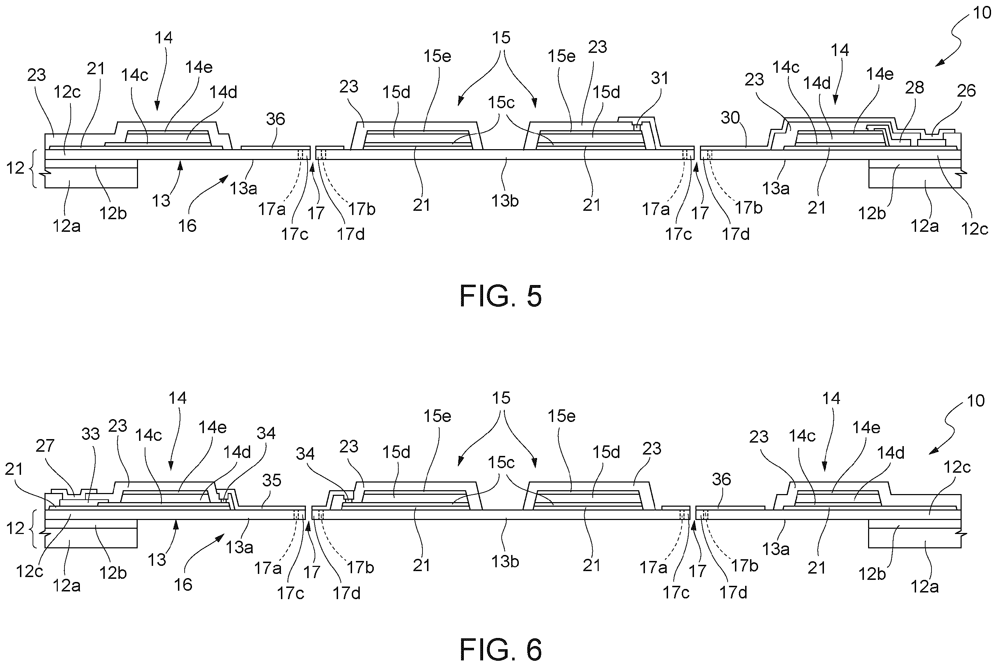

The supporting frame 12 is of semiconductor material and has a cavity 16 (Figures 5 and 6) open on one side and closed on the opposite side by the membrane 13. More precisely, the supporting frame 12 may comprise a substrate, for example of monocrystalline silicon 12a, a dielectric layer 12b and one or more structural layers 12c which may include epitaxial layers, again of monocrystalline silicon, or layers of polycrystalline silicon grown from seed in an epitaxial reactor or deposited layers.

The membrane 13, also of semiconductor material, for example polycrystalline silicon in continuity with the outermost of the structural layers 12c of the supporting frame 12, is connected to the same supporting frame 12 along its perimeter. The membrane 13 may have a thickness comprised for example between 3 µm and 25 µm. In one embodiment, the membrane 13 is polygonal and has an N-fold rotational symmetry with respect to an axis perpendicular to the membrane and passing through the center, with N being an integer. It is understood that a body is provided with an N-fold rotational symmetry with respect to an axis when the body is invariant for rotations of 360°/N around the axis. For example, the membrane 13 may have the shape of a regular octagon. Furthermore, an N-fold rotational symmetry with N even may be advantageous in terms of balancing the stresses (e.g., for the arrangement of dummy connections, as explained in detail below).

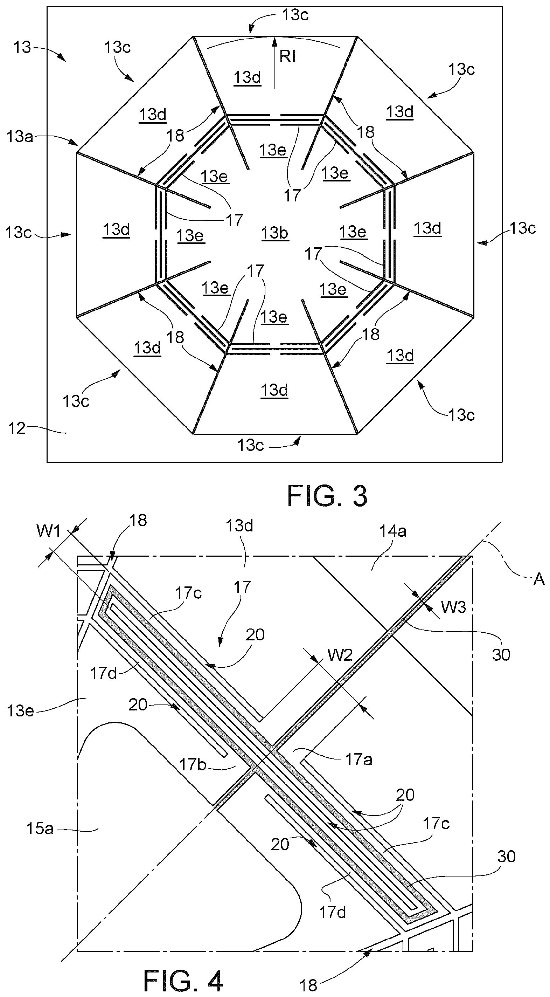

With reference, in particular, to Figure 3, which for clarity shows only the supporting frame 12 and the membrane 13, the membrane 13 has a peripheral portion 13a, that accommodates the peripheral piezoelectric actuator 14 (Figure 2), and a central portion 13b, that accommodates the central piezoelectric actuator 15. The peripheral portion 13a and the central portion 13b of the membrane 13 are coupled to each other by connection portions of the same membrane 13 which define elastic elements 17. In a radial direction, the peripheral portion 13a and the central portion 13b may each extend for a distance comprised, for example, between 30% and 65% of an inscribed radius RI of the membrane 13, which is a regular polygon. In the embodiment of Figures 2-6, for example, the peripheral portion 13a and the central portion 13b occupy, respectively, about 40% and about 55% of the inscribed radius RI.

Furthermore, the membrane 13 is divided into a plurality of sectors 13c, delimited by radial slits 18 that extend in a radial direction from respective vertices of the membrane 13 towards the central portion 13b. Towards the outside, the radial slits 18 may reach the margin of the membrane 13 or even the supporting frame 12, in accordance with design preferences; towards the inside, however, the radial slits 18 extend for a section comprised between a quarter and two thirds of the central portion 13b of the membrane 13, here in particular for about one third. In one embodiment, the radial slits 18 all have the same width. Furthermore, the width of the radial slits 18 is lower than twice a thickness of a low-frequency viscous boundary layer of air (e.g. 100 Hz), in particular in an operating temperature range comprised for example between -20 °C and +40 °C. In one embodiment, the width is lower than the thickness of the low-frequency viscous boundary layer of air and is in any case not greater than 10 µm, e.g. 5 µm. Furthermore, a ratio between the width and a thickness of the membrane 13 is not greater than 1.

In the peripheral portion 13a of the membrane 13, the radial slits 18 define cantilever elements 13d of substantially trapezoidal shape, one in each sector 13c. In the central portion 13b of the membrane 13, the radial slits 18 define tabs 13e, one in each sector 13c. In particular, in each sector 13c the cantilever element 13d has a major base connected to the supporting frame 12 and a minor base connected to the corresponding tab 13e of the central portion 13b of the membrane 13 by a respective elastic element 17.

With reference, in particular, to the enlargement of Figure 4, each elastic element 17 is formed directly by a portion of the membrane 13 and is symmetrical with respect to an axis A that extends along a radial direction of the membrane 13 corresponding to the bisector of the respective sector 13c. The elastic elements 17 are identical to each other and for convenience reference will be made hereinafter to only one of them, being understood that what is described also applies to all the others. The elastic element 17 comprises an outer anchor 17a, an inner anchor 17b, outer arms 17c and inner arms 17d. The outer anchor 17a and the inner anchor 17b are fixed respectively to the cantilever element 13d and to the tab 13e of the respective sector 13c of the membrane 13 along the axis A. The outer arms 17c and the inner arms 17d are parallel to each other and are connected to each other, to the outer anchor 17a and to the inner anchor 17b so as to form a slot. In more detail, the outer arms 17c extend perpendicular to the axis A in opposite directions from the outer anchor 17a up to the radial slits 18 that delimit the respective sector 13c. Similarly, the inner arms 17d extend perpendicular to the axis A in opposite directions from the inner anchor 17b up to the radial slits 18 that delimit the respective sector 13c. The outer arms 17c and the inner arms 17d are joined to each other at the respective distal ends, relative to the outer anchor 17a and the inner anchor 17b.

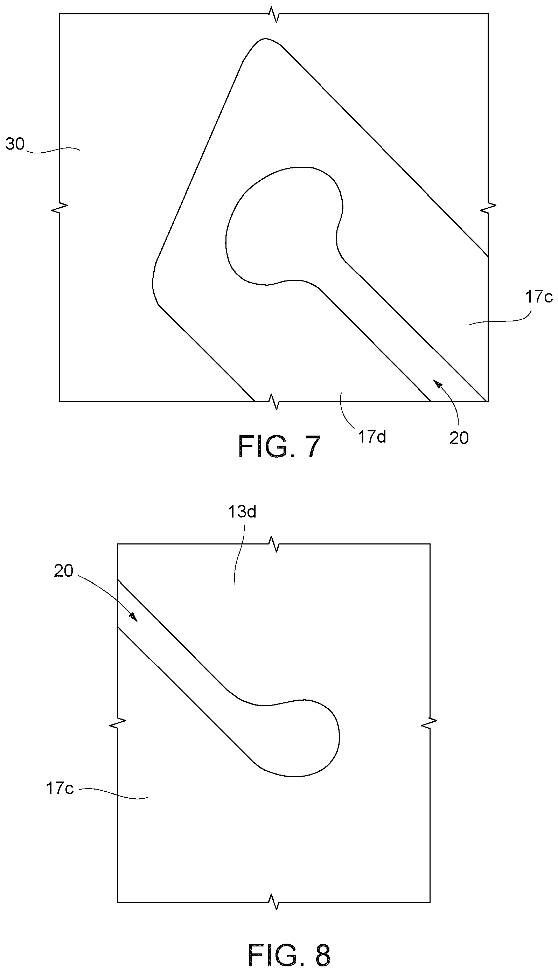

Transversal slits 20, also perpendicular to the axis A, delimit the outer arms 17c and the inner arms 17d and separate them from the cantilever element 13d and the tab 13e of the respective sector 13c of the membrane 13. As shown in the enlargements of Figures 7 and 8, the ends of the transversal slits 20 are widened and rounded to avoid the concentration of force line and prevent the initiation of cracks.

In a direction perpendicular to the transversal slits 20, the outer arms 17c and the inner arms 17d have a width W1 comprised between 30 µm and 70 µm, for example 50 µm, and a length comprised for example between 500 µm and 1.5 mm. The outer anchor 17a and the inner anchor 17b have a width W2 comprised between 70 µm and 150 µm, for example 100 µm.

The peripheral piezoelectric actuator 14 (Figure 2) is arranged at the periphery of the membrane 13 and partly overlaps the supporting frame 12. More precisely, the peripheral piezoelectric actuator 14 comprises a plurality of peripheral actuator portions 14a of substantially trapezoidal shape, each arranged on the cantilever element 13d of a respective sector 13c of the membrane 13 and extending beyond the perimeter of the same membrane 13, on the supporting frame 12. Adjacent peripheral actuator portions 14a are connected to each other by bridges 14b, which have the same structure as the peripheral actuator portions 14a and extend on the supporting frame 12 around distal ends of respective radial slits 18.

The central piezoelectric actuator 15 (Figure 2) is arranged on the central portion 13b of the membrane 13 and comprises central actuator portions 15a that extend in a radial direction from an annular actuator region 15b and form lobes, each on the tab 13e of a respective sector 13c of the membrane 13.

The peripheral piezoelectric actuator 14 and the central piezoelectric actuator 15 use electrical connections that run partly on the membrane 13, including at least some of the elastic elements 17. The structure of the peripheral piezoelectric actuator 14, the central piezoelectric actuator 15, and the electrical connections, as well as the supporting frame 12 and the membrane 13, is shown in detail in the sections of Figures 5 and 6. A dielectric layer 21, for example of silicon oxide, is formed on the outermost of the structural layers 12c and covers the supporting frame 12 and portions of the membrane 13 corresponding to the peripheral piezoelectric actuator 14 and the central piezoelectric actuator 15. The peripheral piezoelectric actuator 14 and the central piezoelectric actuator 15 are formed from the same piezoelectric stack comprising: a bottom metallization structure, for example containing a layer of platinum; a layer of piezoelectric material, for example PZT, on the bottom metallization structure; and a top metallization structure, for example also containing a layer of platinum, on the layer of piezoelectric material. In particular, the peripheral piezoelectric actuator 14 and the central piezoelectric actuator 15 comprise respectively: a bottom peripheral electrode 14c and a bottom central electrode 15c, formed from the bottom metallization structure and arranged on respective portions of the dielectric layer 21; a peripheral piezoelectric body 14d and a central piezoelectric body 15d, formed from the piezoelectric layer and arranged on the bottom peripheral electrode 14c and the bottom central electrode 15c, respectively; and an top peripheral electrode 14e and an top central electrode 15e, formed from the top metallization structure and arranged on the peripheral piezoelectric body 14d and the central piezoelectric body 15d, respectively. The peripheral actuator portions 14a and the bridges 14b connecting them are parts of the peripheral piezoelectric actuator 14 and have the same general structure. A passivation structure 23, for example comprising a layer of silicon nitride and possibly covered by one or more electrically insulating layers, protects the supporting frame 12, the peripheral piezoelectric actuator 14 and the central piezoelectric actuator 15. Outside the peripheral piezoelectric actuator 14 and the central piezoelectric actuator 15, the surface of the membrane 13 opposite to the cavity 16 is substantially free.

Pads 25, 26, 27 on the supporting frame 12 (Figure 2) are accessible for biasing, respectively, the top peripheral electrode 14e, the top central electrode 15e and the bottom peripheral electrode 14c, which is maintained at the same potential as the bottom central electrode 15c as explained below.

The pad 25 is coupled to the top peripheral electrode 14e through a first buried metal line 28, for example of copper, aluminum or an alloy thereof, which extends on the dielectric layer 21 and is incorporated into the passivation structure 23.

The pad 26 is coupled to the top central electrode 15e (Figure 5) through a first exposed metal line 30, made of a conductive material that is immune to oxidation by exposure to the atmosphere and does not require passivation, for example gold or platinum. The first exposed metal line 30 extends along an arbitrary path from the pad 26 to the periphery of the membrane 13 and from there in a radial direction along the bisector of one of the sectors 13c. More precisely (Figures 2 and 5), the first exposed metal line 30 runs on the passivation structure 23 above the supporting frame 12 and the peripheral piezoelectric actuator 14, then on the free part of the cantilever element 13d, on the elastic element 17 and again along the bisector of the affected sector 13c on the tab 13e, up to the corresponding actuator central portion 15a. A radially inner end of the first exposed metal line 30 overlaps an edge of the actuator central portion 15a and electrically coupled thereto by an interconnect 31, for example of copper, aluminum or an alloy thereof, through the passivation structure 23. In particular, the first exposed metal line 30 extends symmetrically on the outer arms 17c and on the inner arms 17d of the spring element 17. In one embodiment, the first exposed metal line 30 is formed directly on the membrane 13, where the piezoelectric actuators 14, 15 are not present, and on the elastic element 17. The first exposed metal line 30 (Figure 4) has a width W3 smaller than the width W1 of the outer arms 17c and the inner arms 17d, in one embodiment not greater than half the width W1 and for example equal to 20 µm.

The pad 27 (Figure 6) is coupled to the bottom peripheral electrode 14c through a second buried metal line 33, that extends on the dielectric layer 21 and is incorporated into the passivation structure 23.

The bottom peripheral electrode 14c is coupled to the bottom central electrode 15c and maintained at the same potential through a second exposed metal line 35 that extends along the bisector of another of the sectors 13c of the membrane 13, different from the sector 13c accommodating the first exposed metal line 30. In a non-limiting embodiment, the sector 13c accommodating the second exposed metal line 35 is rotated by 90° with respect to the sector 13c accommodating the first exposed metal line 30. The second exposed metal line 35 has ends overlapping respective extensions of the bottom peripheral electrode 14c and the bottom central electrode 15c and electrically coupled thereto by interconnects 34 through the passivation structure 23. Furthermore, between the bottom peripheral electrode 14c and the bottom central electrode 15c, the second exposed metal line 35 extends on the cantilever element 13d, the elastic element 17 and the tab 13e of the respective sector 13c of the membrane 13. The second exposed metal line 35 is made of the same material as the first exposed metal line 30 and has the same shape, except for a rotation by 90° and the portion of the first exposed metal line 30 that extends on the peripheral piezoelectric actuator 14 and the supporting frame 12.

In one embodiment, dummy metal lines 36 are formed on sectors 13c of the membrane 13 opposite with respect to those accommodating the first exposed metal line 30 and the second exposed metal line 35. The dummy metal lines 36 extend between the peripheral actuator portions 14a and the central actuator portions 15a and on the elastic elements 17 of the respective sectors 13c of the membrane 13, are made of the same material and have the same shape as the first exposed metal line 30 and the second exposed metal line 35. The dummy metal lines 36 are decoupled from the piezoelectric actuators 14, 15, are floating and have the sole function of mechanically balancing the stresses applied to the membrane 13 by the first exposed metal line 30 and the second exposed metal line 35.

It is understood that the arrangement of the first exposed metal line 30, the second exposed metal line 35 and any dummy metal lines 36 may however be different from what has been described so far.

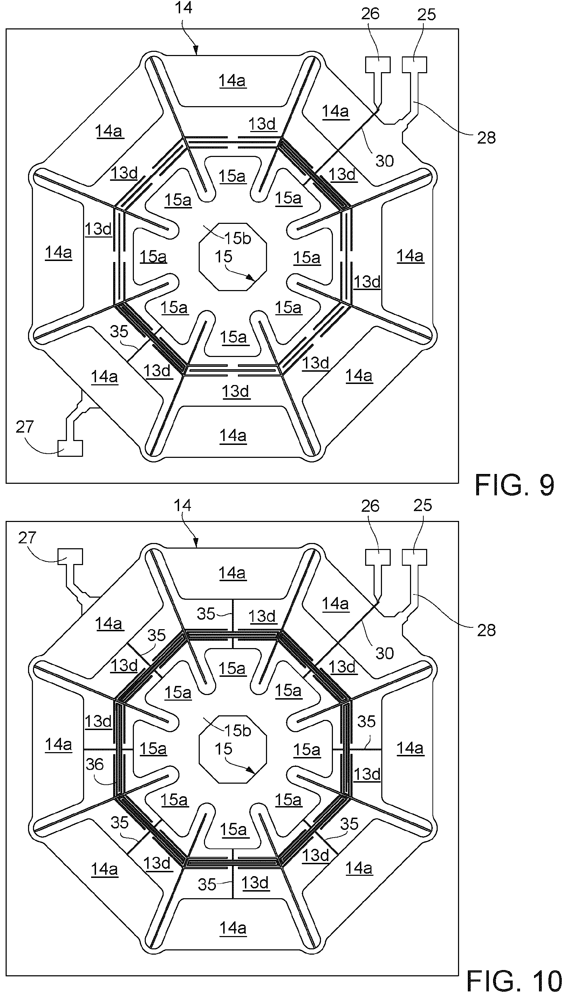

For example, in the embodiment of Figure 9, the second exposed metal line 35 is opposite to the first exposed metal line 30 and dummy metal lines 36 are not present.

In the embodiment of Figure 10, dummy metal lines 36 are present in all sectors 13c of the membrane 13 not occupied by the first exposed metal line 30 and the second exposed metal line 35.

In the example described above, the metal lines that connect the central piezoelectric actuator 15 to the pads 26, 27, as well as the dummy metal lines 36 if any, are exposed and free of passivating coating and, in general, of any coating. This is possible because such metal lines are made of a metal immune to oxidation by exposure to the atmosphere and the absence of coating is particularly advantageous because the effects on the deformability of the membrane 13 and the elastic elements 17 are minimal and, in fact, completely negligible. However, a passivating coating and/or another coating might still be present in accordance with design preferences, for example if the deformability of the membrane and the elastic elements is equally considered satisfactory. In this case, the metal lines would not be directly exposed to the atmosphere.

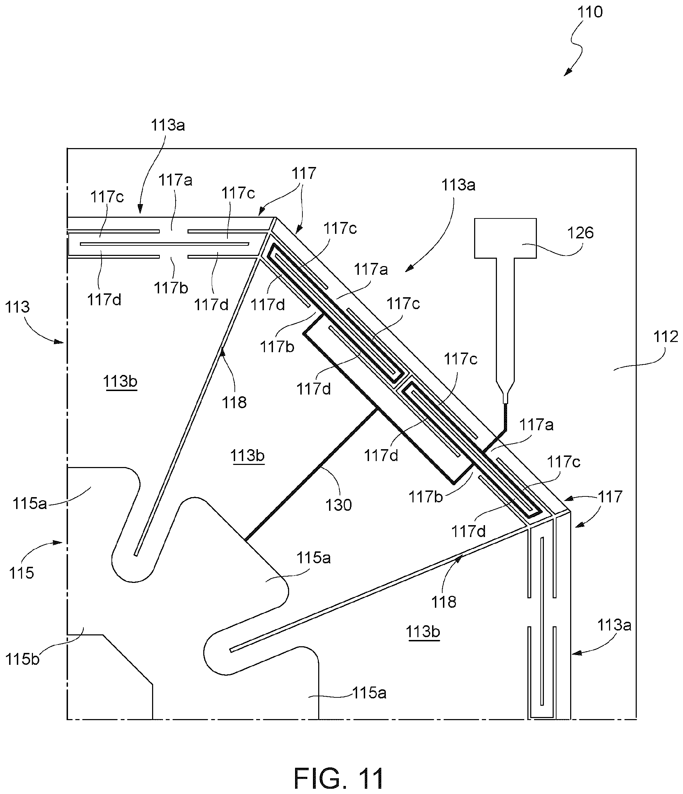

With reference to Figure 11, an electroacoustic transducer 110 comprises a supporting frame 112, a membrane 113 and a piezoelectric transducer, in particular a piezoelectric actuator 115. The membrane 113, for example of polycrystalline silicon, has the shape of a regular polygon with an N-fold rotational symmetry, for example an octagon, and is connected to the supporting frame 112 along its own perimeter by elastic elements 117. The membrane 113 is divided into a plurality of sectors 113a, delimited by radial slits 118 which extend in a radial direction from respective vertices of the membrane 113 towards the inside, up to a distance from the center of the same membrane 113. In each sector 113a of the membrane 113, the radial slits 118 delimit tabs 113b coupled to the supporting frame 112 by respective elastic elements 117. More precisely, each tab 113b is coupled to the supporting frame 112 by a plurality of respective elastic elements 117, here two, arranged symmetrically to each other with respect to a bisector of the respective sector 113a. Each elastic element 117 comprises an outer anchor 117a, fixed to the supporting frame 112, an inner anchor 17b fixed to the tab 113b, outer arms 117c and inner arms 117d. The use of multiple elastic elements 117 in each sector 113a allows suitable mobility of the membrane 113 to be ensured, preventing the elastic elements 117 from being weakened due to the dimensions at the periphery of the tabs 113a.

The piezoelectric actuator 115 is arranged on a central portion of the membrane 113 and comprises portions 115a that extend in a radial direction from an annular actuator region 115b and form lobes, each on the tab 113b of a respective sector 113a of the membrane 113. The piezoelectric actuator 115 has the structure of the actuators 14, 15 already described, with a bottom electrode, a piezoelectric body and an top electrode and is not illustrated in detail.

A pad 126 on the supporting frame 112 is accessible for biasing the piezoelectric actuator 115, in particular the top electrode (not shown). The pad 126 is coupled to the piezoelectric actuator 115 through an exposed metal line 130, made of a conductive material that is immune to oxidation by exposure to the atmosphere and does not require passivation, for example gold or platinum. The exposed metal line 130 extends along an arbitrary path from the pad 126 to the periphery of the membrane 113, on both elastic elements 117 of one of the sectors 113a and from there in a radial direction along the bisector of the same sector 113a. The exposed metal line 130 has a radially inner end coupled to an edge of the respective actuator portion 115a. A further exposed metal line, formed in a similar manner and not illustrated here, may be envisaged in another sector 113a of the membrane 113 for biasing the bottom electrode of the piezoelectric actuator 115.

The metal lines according to the invention allow biasing piezoelectric actuators placed in central portions of membranes connected to the respective supporting body by elastic elements without appreciably modifying the elastic behavior of the same membranes. More precisely, the use of metals immune to oxidation by exposure to air allows forming exposed metal lines that do not require passivation structures or, if desired in accordance with design preferences, providing the metal lines with very thin passivating coatings at least on the membrane and on the elastic elements. In other words, the addiction of material on the membrane may be strictly limited to the metal of the same lines, avoiding superfluous structures that would stiffen the membrane and might reduce the dynamics. Alternatively, when the deformability of the membrane and the elastic elements is still considered satisfactory in accordance with design preferences, the metal lines may be provided with thin coatings, in particular passivating coatings, which do not substantially alter the performances of the membrane and the elastic elements.

Furthermore, very high conductivity materials may be used and the dimensions of the metal lines may be correspondingly reduced. In general, this avoids stiffening the membrane, to the advantage of the sound pressure level (for transmitters or actuators) and the sensitivity (for receivers or sensors). Furthermore, the metal lines may be narrow enough to run on the elastic elements, without significantly altering their mechanical properties and without the need for dedicated membrane portions.

Finally, it is clear that modifications and variations may be made to the electroacoustic transducer described, without departing from the scope of the present invention, as defined in the attached claims.

It is understood, in particular, that electroacoustic transducers according to the invention may be effectively used in devices other than micro-speakers, such as, but not limited to, microphones and probes for ultrasound inspection and imaging. While maintaining the same general structure, the electroacoustic transducers may operate either as transmitters (for example micro-speakers) or as receivers (for example microphones) and, in some applications, in a reversible manner both as transmitters and as receivers (for example, in ultrasound imaging probes - PMUT). This is possible because the piezoelectric transducers present on the membrane may operate as actuators in transmitters, converting electrical signals into deformations of the membrane to generate acoustic waves, and as sensors in receivers, converting deformations of the membrane caused by impinging acoustic waves into electrical signals.

## Claims

1. A microelectromechanical electroacoustic transducer comprising:
a supporting frame (12; 112), containing semiconductor material;
a membrane (13; 113) of semiconductor material connected to the supporting frame (12; 112) along a perimeter;
a central piezoelectric transducer (15; 115) on a central portion (13b) of the membrane (13; 113);
elastic elements (17; 117), defined by respective portions of the membrane (13; 113), the central portion (13b) of the membrane (13; 113) being connected to the supporting frame (12; 112) by the elastic elements (17; 117); and
metal lines (30, 35, 36; 130) extending on respective elastic elements (17; 117) and on the central portion (13b) of the membrane (13; 113) from the elastic elements (17; 117) to the central piezoelectric transducer (15; 115).

2. The electroacoustic transducer according to claim 1, wherein the metal lines (30, 35, 36; 130) are of a metal immune to oxidation by exposure to the atmosphere, preferably gold or platinum.

3. The electroacoustic transducer according to claim 2, wherein the metal lines (30, 35, 36; 130) are free of coating and are exposed on the membrane (13; 113) and on the elastic elements (17; 117), preferably at any place on the membrane (13; 113) and on the elastic elements (17; 117).

4. The electroacoustic transducer according to any one of claims 2 or 3, wherein the elastic elements (17; 117) are free of piezoelectric material.

5. The electroacoustic transducer according to any of the preceding claims, wherein the supporting frame (12; 112) has a cavity (16) open on one side and closed on the opposite side by the membrane (13; 113) and wherein the metal lines (30, 35, 36; 130) extend on a face of the membrane (13; 113) opposite to the cavity (16).

6. The electroacoustic transducer according to any one of the preceding claims, comprising a peripheral piezoelectric transducer (14), wherein the membrane (13) has a peripheral portion (13a), coupled to central portion (13b) by the elastic elements (17; 117), and the peripheral piezoelectric transducer (14) is arranged on the peripheral portion (13a) of the membrane (13).

7. The electroacoustic transducer according to claim 6, wherein the membrane (13; 113) is divided into sectors (13c; 113a) by radial slits (18; 118) extending from the periphery of the membrane (13; 113) into the central portion (13b) and in the peripheral portion (13a) of the membrane (13) the radial slits (18) define a cantilever element (13d) of substantially trapezoidal shape in each sector (13c); and wherein the peripheral piezoelectric transducer (14) comprises a plurality of peripheral actuator portions (14a), each arranged on the cantilever element (13d) of a respective sector (13c) of the membrane (13).

8. The electroacoustic transducer according to claim 7, wherein the peripheral actuator portions (14a) of the peripheral piezoelectric transducer (14) extend beyond the perimeter of the membrane (13), on the supporting frame (12) and adjacent peripheral actuator portions (14a) are connected to each other by bridges (14b) extending on the supporting frame (12) around distal ends of respective radial slits (18).

9. The electroacoustic transducer according to claim 7 or 8, wherein in the central portion (13b) of the membrane (13) the radial slits (18) define a tab (13e) in each sector (13c); and wherein the cantilever element (13d) and the tab (13e) of each sector (13c) of the membrane (13) are coupled to each other by the respective elastic element (17).

10. The electroacoustic transducer according to claim 9, wherein the central piezoelectric actuator (15) comprises central actuator portions (15a) extending in a radial direction from an annular actuator region (15b), each on the tab (13e) of a respective sector (13c) of the membrane (13).

11. The electroacoustic transducer according to any one of claims 7 to 10, wherein each elastic element (17; 117) comprises an outer anchor (17a; 117a), directly or indirectly connected to the supporting frame (12; 112), an inner anchor (17b; 117b), connected to the central portion (13b) of the membrane (13; 113), outer arms (17c; 117c) extending in opposite directions from the outer anchor and inner arms (17d; 117d) extending in opposite directions from the inner anchor (17b; 117b).

12. The electroacoustic transducer according to claim 11, wherein in each elastic element (17; 117) the outer arms (17c; 117c) and the inner arms (17d; 117d) are parallel to each other and are connected to each other, to the outer anchor (17a; 117a) and to the inner anchor (17b; 117b) so as to form a slot.

13. The electroacoustic transducer according to claim 11 or 12, wherein the metal lines (30, 35, 36; 130) extend on the outer anchor (17a; 117a), the inner anchor (17b; 117b), the outer arms (17c; 117c) and the inner arms (17d; 117d).

14. The electroacoustic transducer according to any of claims 7 to 10, wherein the central piezoelectric transducer (15; 115) comprises a bottom electrode (15c), a piezoelectric body (15d) on the bottom electrode (15c) and a top electrode (15e) on the piezoelectric body (15d); and wherein the metal lines (30, 35, 36; 130, 135) comprise a first metal line (30; 130) connecting the top electrode (15e) to a first pad (26; 126) on the supporting frame (12; 112) through the respective sector (13c; 113a) of the membrane (13; 113) and a second metal line (35; 135) connecting the bottom electrode (15c) to a second pad (27; 127) on the supporting frame (12; 112) through the respective sector (13c; 113a) of the membrane (13; 113).

15. The electroacoustic transducer according to claim 13, wherein the metal lines (30, 35, 36) comprise dummy metal lines (36) in sectors (13c) of the membrane (13) opposite to the sectors (13c) accommodating the first metal line (30) and the second metal line (35), wherein the dummy metal lines (36) extend at least on the elastic element (17) of the respective sector (13c; 113a) of the membrane (13) and up to the central piezoelectric actuator (15) and wherein the dummy metal lines (36) are electrically insulated from the central piezoelectric actuator (15).
